Europäisches Patentamt

European Patent Office

Office européen des brevets

(11) Veröffentlichungsnummer : **0 531 703 B1**

(12) # EUROPÄISCHE PATENTSCHRIFT

(45) Veröffentlichungstag der Patentschrift :
**19.07.95 Patentblatt 95/29**

(51) Int. Cl.$^6$ : **G01R 33/00**

(21) Anmeldenummer : **92113225.4**

(22) Anmeldetag : **03.08.92**

(54) **Verfahren zur Lokalisierung von elektrophysiologischen Aktivitäten.**

(30) Priorität : **16.08.91 DE 4126949**

(43) Veröffentlichungstag der Anmeldung :
**17.03.93 Patentblatt 93/11**

(45) Bekanntmachung des Hinweises auf die
Patenterteilung :
**19.07.95 Patentblatt 95/29**

(84) Benannte Vertragsstaaten :
**DE FR GB IT NL**

(56) Entgegenhaltungen :
**EP-A- 0 156 084**
**EP-A- 0 394 662**
**EP-A- 0 449 231**

(56) Entgegenhaltungen :
**JOURNAL OF APPLIED PHYSICS. Bd. 59, Nr. 2, 15. Januar 1986, NEW YORK US Seiten 645 - 650 P. CARELLI ET AL. 'Localization of biological sources with arrays of superconducting gradiometers'**
**IEEE TRANSACTIONS ON MAGNETICS. Bd. 25, Nr. 3, Mai 1989, NEW YORK US Seiten 2726 - 2731 K. MORI 'Application of Weight Functions to the Magnetic Localization of an Object'**
**IEEE TRANSACTIONS ON BIO-MEDICAL ENGINEERING. Bd. 35, Nr. 7, Juli 1988, NEW YORK US Seiten 551 - 560 P.C. RIBEIRO**

(73) Patentinhaber : **SIEMENS AKTIENGESELLSCHAFT**
**Wittelsbacherplatz 2**
**D-80333 München (DE)**

(72) Erfinder : **Scholz, Bernhard, Dr.**
**Jägersteig 25**
**W-8550 Forchheim (DE)**

**Beschreibung**

Die Erfindung betrifft ein Verfahren zur Lokalisierung von im Innern eines Lebewesens in einem Untersuchungsvolumen ablaufenden elektrophysiologischen Aktivitäten, die außerhalb des Untersuchungsvolumens ein meßbares magnetisches und elektrisches Feld erzeugen, welches durch die Wirkung äquivalenter Stromdipole, die sich innerhalb des Untersuchungsvolumens befinden, darstellbar ist.

Sei langem werden die von elektrophysiologischen Aktivitäten erzeugten elektrischen Felder als Elektroenzephalogramme (EEG) und Elektrokardiogramme (EKG) in der medizinischen Diagnostik ausgewertet. Es besteht auch die Möglichkeit, die von den elektrophysiologischen Aktivitäten erzeugten Magnetfelder mit Hilfe von biomagnetischen Meßsystemen zu messen.

Der grundsätzliche Aufbau eines biomagnetischen Meßsystems ist beispielsweise in der EP-A1-0 359 864 beschrieben. Mit einer Sensoranordnung werden dabei die äußerst schwachen Magnetfelder, die von elektrophysiologischen Aktivitäten erzeugt werden, gemessen. Die Sensoranordnung umfaßt dabei im allgemeinen mehrere, in einem Array angeordnete Gradiometer. Durch Auswertung der Signale der Gradiometer wird die Position der elektrophysiologischen Aktivität, von der die Magnetfelder ausgehen, im Untersuchungsvolumen ermittelt. Dazu wird die Position von äquivalenten Stromdipolen bestimmt, die den elektrophysiologischen Aktivitäten entsprechen. Ausgehend von den Werten des Magnetfeldes an einer begrenzten Anzahl von Meßraumpunkten müssen daher die Stromdipole aufgrund des gemessenen Feldes nach Ort, Stärke und Richtung ermittelt werden. Dieses Problem wird auf der Basis von Modellen für das biologische Gewebe im Untersuchungsvolumen und für die äquivalenten Stromquellen, die das externe Feld erzeugen, gelöst.

Bei einem bekannten Verfahren erfolgt die Lösung nach dem Verfahren der kleinsten Quadrate, wie es z.B. beschrieben ist in J. Sarvas, "Basic Mathematical and Electromagnetic Concepts of the Biomagnetic Inverse Problem", Physics in Medicine and Biology, Vol. 1932, 1987, Seiten 11 bis 22. Die zugrundeliegenden Parameter bei einem Stromdipol sind seine Position im Untersuchungsvolumen und sein Moment. In dem Verfahren gehen die Positionen nicht-linear ein, während die Momente linear eingehen. Die Minimierung der Funktion der kleinsten Quadrate oder least-squares-Funktion kann bezüglich aller Parameter oder auch nur der linearen Parameter erfolgen. Die least-squares-Funktion wird auch Zielfunktion genannt.

Ein erstes, aber sehr rechenzeitintensives Minimierungsverfahren ist die Suche der kleinsten Quadrate im gesamten Parameterraum. Dieses Minimierungsverfahren kann Lösungen bei einer begrenzten Anzahl von Stromdipolen liefern. Um keine unzumutbar langen Rechenzeiten zu benötigen, geht man in der Praxis nur von einem einzigen Stromdipol aus. Zusätzlich kann der dabei sonst sechsdimensionale Parameterraum durch spezielle Modelle des Untersuchungsvolumens verringert werden. Für kardiologische Untersuchungen wird das Untersuchungsvolumen durch einen homogenen, leitfähigen, unendlichen Halbraum und für zerebrale Untersuchungen durch eine homogene leitfähige Kugel ersetzt. Bei einem Ein-Dipol-Modell ist der Parameterraum dann fünfdimensional, bei einem Zwei-Dipol-Modell zehndimensional.

Eine weitere Parameterreduzierung läßt sich durch die Einführung von lokal-optimalen Stromdipolen erzielen. Damit erfolgt die Minimierung der Zielfunktion bezüglich der linearen Parameter, also des Dipolmoments durch Auffinden der Lösungen eines korrespondierenden Systems linearer Gleichungen. Diese Linearisierung wurde schon in der eingangs erwähnten Literaturstelle Sarvas et al. und in J.C. Mosher, P.S. Lewis, R. Leahy, M. Singh, "Multiple dipole modeling of spatio-temporal MEG data", Proceedings of SPIE Conference on Digital Image Synthesis and Inverse Optics, Vol. 1351, Juli 1990, San Diego, pp. 364-375 diskutiert. Die linearen Gleichungen verbinden die Dipolmomente und die Meßwerte an den Meßraumpunkten. Sie können im über- und im unterbestimmten Fall betrachtet werden. Die entsprechende überbestimmte Lösung führt zum Konzept der lokal-optimalen Dipol-Momente. Dabei wird für jeden Untersuchungsvolumenpunkt das Moment eines dort sich befindenden Stromdipols so bestimmt, daß das vom Stromdipol an den Meßraumpunkten erzeugte Feld am besten mit dem an den Meßraumpunkten gemessenen Feld übereinstimmt.

Lokal-optimale Dipol-Momente hängen von den Dipol-Positionen ab. Die Zielfunktion kann daher ausschließlich als Funktion des Raumes betrachtet werden. Damit ist die Dimension des Parameterraums erheblich reduziert. Das hat nützliche Konsequenzen und ermöglicht eine Verbesserung des Lokalisierungs-Algorithmus. Außerdem kann in einem Ein-Dipol-Modell die gesamte Zielfunktion im interessierenden Bereich graphisch dargestellt werden.

Die Zielfunktion F kann für punktförmige Sensoren oder Detektoren aufgrund folgender Gleichung ermittelt werden:

$$F = \frac{1}{2} \sum_{i=1}^{M} (b_i - m_i)^2. \qquad (1)$$

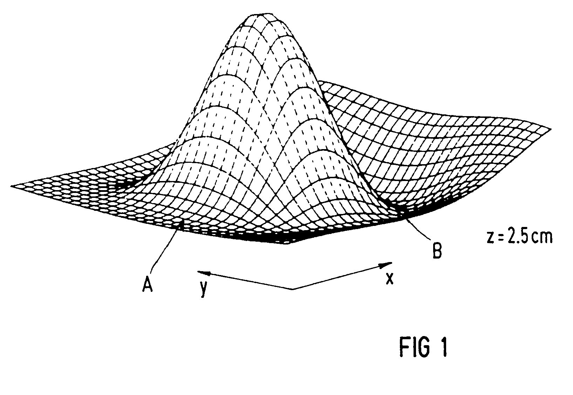

Dabei ist $b_i$ die theoretische oder von einem Stromdipol erzeugte und $m_i$ die gemessene magnetische Feldkomponente entlang der Normalen jedes Detektors, also das an den Meßraumpunkten entlang der durch die Lage des Detektors vorgegebenen Normalen gemessene Feld; M ist die Anzahl der Detektoren oder Meßraumpunkte. Eine Zielfunktion mit lokal-optimalen Stromdipol-Momenten im Ein-Dipol-Modell ist beispielhaft in FIG 1 dargestellt. Wie bereits erwähnt, wird zur Ortsbestimmung des Dipols das Minimum der Zielfunktion bezüglich der Stromparameter gesucht. Bei den bekannten Iterationsverfahren, wie z.B. der Levenberg-Marquardt-Algorithmus, besteht immer die Gefahr, daß nicht ein globales Minimum, sondern ein Nebenminimum gefunden wird, in FIG 1 z.B. ein Punkt B anstelle des Punktes A.

Aufgabe der Erfindung ist es nun, ein Lokalisierungsverfahren anzugeben, mit dem bei vernünftiger Rechenzeit auch mehrere Stromdipole lokalisiert werden können. Ferner sollen Fehllokalisierungen durch Nebenminima verhindert werden.

Die Aufgabe wird durch ein Verfahren mit folgenden Schritten gelöst:
- Messen des magnetischen und/oder elektrischen Feldes in einer ersten Anzahl von Meßraumpunkten außerhalb des Untersuchungsvolumens mit einer ersten Anzahl von Meßkanälen,
- Berechnen von lokal-optimalen Stromdipol-Kombinationen, die sich an einer zweiten Anzahl von jeweils unterschiedlichen Untersuchungs-Raumpunkten innerhalb des Untersuchungsvolumens befinden und die jeweils an den Meßraumpunkten ein magnetisches bzw. elektrisches Feld erzeugen, das mit dem an den Meßraumpunkten gemessenen Feld am besten übereinstimmt,
- Berechnen einer least-squares-Funktion auf der Grundlage der lokal-optimalen Stromdipol-Kombinationen, die das von den lokal-optimalen Stromdipol-Kombinationen erzeugte Feld an der ersten Anzahl von Meßraumpunkten mit dem gemessenen Feld an diesen Meßraumpunkten vergleicht, wobei die least-squares-Funktion nur eine Funktion von Raumpunkten im Untersuchungsvolumen ist,
- Berechnen einer exponentiellen Wahrscheinlichkeitsdichtefunktion, deren negativer Exponent die least-squares-Funktion enthält, und
- Berechnen eines Orts-Erwartungswertes der Stromdipol-Kombination mittels der Wahrscheinlichkeitsdichtefunktion, wobei der Orts-Erwartungswert aus der mit der Gesamtwahrscheinlichkeit normierten Summe der mit der entsprechenden Wahrscheinlichkeitsdichtefunktion gewichteten Untersuchungs-Raumpunkte gebildet wird und den Orten der äquivalenten Stromdipole im Untersuchungsvolumen entspricht.

Dadurch, daß zunächst die lokal-optimalen Stromdipol-Kombinationen bestimmt werden, ist die Voraussetzung geschaffen, die Lokalisierung der äquivalenten Stromdipole in einer vernünftigen Rechenzeit durchzuführen. Der Weg über die exponentielle Wahrscheinlichkeitsdichtefunktion verhindert Fehllokalisationen durch Nebenmaxima, weil die Struktur der Zielfunktion im gesamten Untersuchungsraum berücksichtigt wird.

Eine vorteilhafte Ausgestaltung zeichnet sich dadurch aus, daß der Exponent in seinem Nenner eine über alle Meßkanäle ermittelte quadratische Meßwert-Rauschamplitude enthält. Damit beeinflußt auch das Rauschen die Breite der Wahrscheinlichkeitsdichtefunktion und wird bei der Bestimmung des Lokalisierungsfehlers mit berücksichtigt.

Eine weitere vorteilhafte Ausgestaltung ist dadurch gekennzeichnet, daß die lokal-optimalen Stromdipol-Kombinationen jeweils nur einen lokal-optimalen Stromdipol enthalten. Die Beschränkung auf ein Ein-Dipol-Modell verringert erheblich die zur Bestimmung der Parameter benötigte Rechenzeit.

Eine weitere vorteilhafte Ausgestaltung des Verfahrens ist dadurch gekennzeichnet, daß aus dem zweiten Moment der Wahrscheinlichkeitsdichtefunktion die Standardabweichung berechnet wird, wobei die Standardabweichung ein Maß für den Fehler bei der Ortsbestimmung des äquivalenten Stromdipols ist. Die Angabe des Fehlers der Lokalisierung liefert wichtige Informationen bei der diagnostischen Auswertung.

Die in den Ansprüchen 5 bis 9 gekennzeichneten bildlichen Darstellungen der verschiedenen Kenngrößen der Wahrscheinlichkeitsdichtefunktion erleichtern dem Arzt die Diagnose.

Ein Ausführungsbeispiel der Erfindung wird nachfolgend anhand der Figuren 2 bis 6 erläutert. Es zeigen:
FIG 2 bis 5 Plots der Wahrscheinlichkeitsdichtefunktion in der x-y Ebene in verschiedenen Tiefen (z-Richtung) und
FIG 6 eine bildliche Darstellung der Wahrscheinlichkeitsdichtefunktion in einer Ebene des Untersuchungsvolumens.

Das Ausführungsbeispiel ist wegen der anschaulichen Darstellungsmöglichkeit auf ein Ein-Dipol-Modell beschränkt. Analoges gilt für ein Mehr-Dipol-Modell oder eine Stromdipol-Kombination, jedoch ist dann die Dimension des Parameterraums entsprechend größer. So ist ist z.B. bei einem Zwei-Dipol-Modell der Parameterraum sechsdimensional und bei einem Drei-Dipol-Modell neundimensional.

Das Lokalisierungsverfahren beruht auf Wahrscheinlichkeitsrechnungen. Die Zielfunktion wird im gesamten interessierenden Gebiet oder Untersuchungsvolumen auf einem Gitter ermittelt. Dadurch ist die Suche nach einem Minimum global, Nebenminima können erkannt werden. Im Ein-Dipol-Modell kann die Suche ohne wesentliche Rechenzeit durchgeführt werden.

Die Position des Minimums der Zielfunktion entspricht im allgemeinen nicht der Position des äquivalenten Stromdipols, wenn die Daten verrauscht sind. Das "rauschfreie" Minimum wird aufgrund von Rauscheffekten in den Meßkanälen verschoben. Deshalb ist ein Algorithmus zur Lokalisierung erwünscht, bei dem die Dipol-Momente auch durch die Struktur der Zielfunktion um das "verrauschte" Minimum bestimmt werden. Der im folgenden erläuterte Algorithmus berücksichtigt auch das Rauschen in den Meßkanälen.

Die ortsabhängige, nicht-Gaußsche Wahrscheinlichkeitsdichtefunktion g(x) des Ortes des äquivalenten Stromdipol ergibt sich aus der nur ortsabhängigen Zielfunktion wie folgt:

$$g(\vec{x}) = e^{-\frac{1}{2}(F(\vec{x})/\sigma_N^2)} \qquad (2)$$

Dabei ist $\sigma_N^2$ die über alle Meßwertkanäle gemittelte quadratische Meßwerte-Rauschamplitude; F ist die Zielfunktion nach der Gleichung (1). Die Wahrscheinlichkeitsdichtefunktion gibt für die vorgegebenen Untersuchungs-Raumpunkte einen Wahrscheinlichkeitsdichtewert an.

Der Ort des äquivalenten Stromdipols ist der Orts-Erwartungswert, der nach der folgenden Vorschrift er-mittelt wird:

$$\langle \vec{x} \rangle = \frac{\sum\limits_{i=1}^{N} \vec{x}_i \, g(\vec{x}_i)}{\sum\limits_{i=1}^{N} g(\vec{x}_i)} \qquad (3)$$

Dabei kennzeichnen die spitzen Klammern <> den Mittelwert, N ist die Anzahl der Untersuchungs-Raumpunkte. Die Summierung muß in dem Bereich, wo die Wahrscheinlichkeitsdichtefunktion g von Null verschieden ist, auf einem genügend feinen Raster durchgeführt werden.

Ferner kann ein individueller Lokalisierungsfehler aufgrund von statistischen Fluktuationen in den Daten bestimmt werden. Dieser ist gegeben durch die Lokalisations-Standardabweichung, die aus dem zweiten Moment der Wahrscheinlichkeitsdichtefunktion berechnet werden werden kann. Die Varianz entlang einer j-Achse beträgt:

$$\sigma_j^2 = \langle x_j^2 \rangle - \langle x_j \rangle^2 \quad (4)$$

wobei

$$\langle x_j^2 \rangle = \frac{\sum\limits_{i} x_{ji}^2 g(\vec{x}_i)}{\sum\limits_{i} g(\vec{x}_i)} \qquad (5)$$

Dabei stellt j die jeweilige Richtung x, y, z dar und läuft entsprechend von 1 bis 3. Eine gesamte Varianz, die unabhängig von Koordinatendrehungen ist, beträgt:

$$\sigma^2 = \sum\limits_{j=1}^{3} \sigma_j^2 . \qquad (6)$$

Sie läßt sich als Kugel um den Ort des Stromdipol deuten.

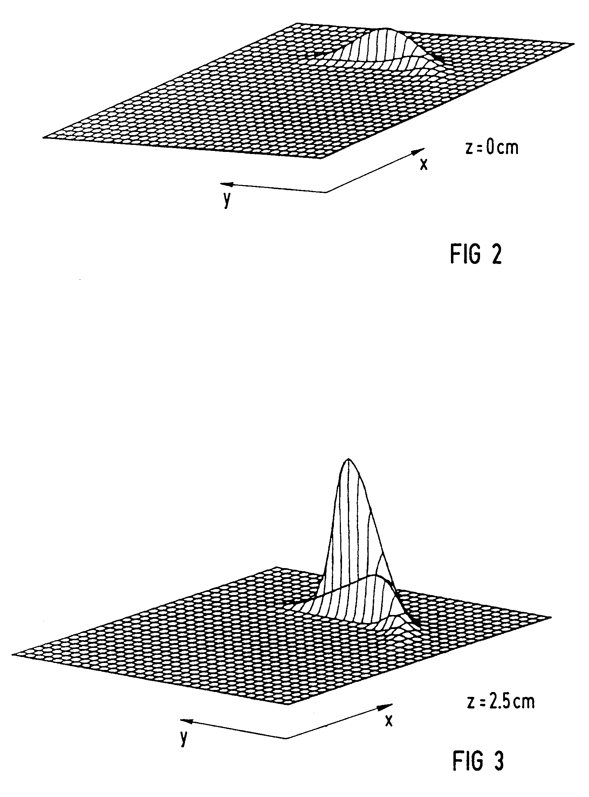

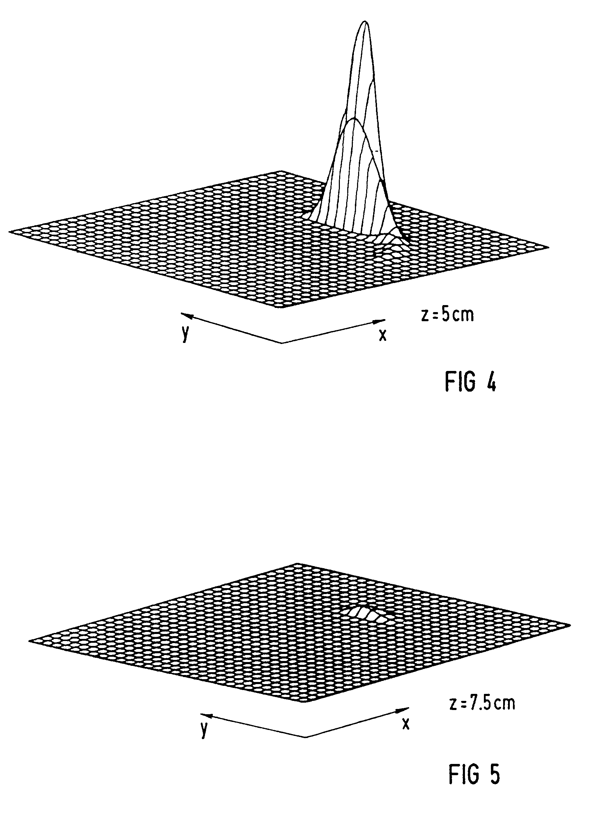

Aufgrund der obigen Berechnungen kann nicht nur der ermittelte Stromdipol-Ort in z.B. einem anatomischen Schnittbild dargestellt werden, sondern auch die Wahrscheinlichkeitsdichtefunktion, wie sie in den Figuren 2 bis 5 für verschiedene Tiefen z im Untersuchungsgebiet dargestellt ist. Aufgrund einer derartigen Darstellung sieht der Betrachter nicht nur den ermittelten Ort, sondern auch die Wahrscheinlichkeitsverteilung und kann sich damit ein Bild machen, wie zuverlässig der ermittelte Stromdipol-Ort ist. Das beschriebene Verfahren ist somit zuverlässiger und aussagekräftiger als herkömmliche Suchverfahren nach dem Minimum der Zielfunktion.

Es können auch nur Bereiche abgebildet werden, in denen die Wahrscheinlichkeitsdichtefunktion eine Schwelle überschreitet. Ferner ist es möglich, das gewonnene Bild entsprechend dem jeweiligen Wert der Wahrscheinlichkeitsdichtefunktion farblich zu kodieren.

Ferner kann der individuelle Fehler für jede Lokalisation numerisch angegeben werden.

Aufgrund der Bildung der Wahrscheinlichkeitsdichtefunktion auf einem zunächst gröberen Gitter kann eine Vorselektrion des relevanten Stromdipol-Bereichs erfolgen und dann im selektierten Bereich auf einem feineren Gitter die Orts-, Fehler- und Wahrscheinlichkeitsberechnung durchgeführt werden.

In Simulationsexperimenten ergab die exponentielle Gewichtung bezüglich der Position das folgende Ergebnis: etwa 56 % der berechneten Dipol-Positionen liegen innerhalb einer Kugel mit dem Radius $\sigma$, etwa 97 % liegen in einer Kugel mit dem Radius $2\sigma$ und mehr als 99,5 % in einer Kugel mit dem Radius $3\sigma$.

Der geschilderte Algorithmus berücksichtigt die Struktur der Zielfunktion im gesamten interessierenden Bereich. Bei herkömmlichen iterativen Lokalisationsmethoden war dies nicht der Fall. Diese finden das lokale Minimum in dem Bereich, zu dem der Startpunkt gehört. Das Stopkriterium bei der Iteration ist üblicherweise auch bei einem Nicht-Minimumort in einem leicht ansteigenden, ringförmigen Tal erfüllt. Diese in FIG 1 dargestellte Struktur der Zielfunktion tritt auf, wenn die Daten monopolar oder quasimonopolar sind, d.h. die Feldwerte haben z.B. überwiegend positive Amplituden. Die globalere Betrachtung der Zielfunktion - zusammen mit der exponentiellen Wichtung - vermeidet, daß die Iteration in ein lokales Minimum oder zu einem falschen Ort im Ring-ähnlichen Tal läuft. Daher ist die Lokalisationsgenauigkeit des vorgestellten Algorithmus nur durch den von den Meßkanälen verursachten Rauschanteil in den Meßwerten begrenzt.

Für tief liegende Dipole verflachen Rauschanteile die Zielfunktion in einem verhältnismäßig großen Bereich um die echte Stromdipol-Position. Dies verursacht oftmals eine beträchtliche Verschiebung des Minimums der Zielfunktion. Selbst wenn ein herkömmlicher Algorithmus dieses Minimum findet, ist das Ergebnis falsch. In dem vorgestellten, auf Wahrscheinlichkeitsbetrachtungen basierenden Algorithmus ergibt eine flache Zielfunktion eine breite Gewichtungsfunktion. Daher berücksichtigt der Positionserwartungswert die Struktur der Zielfunktion um das rausch-bestimmte Minimum.

Für tief liegende Dipole liefert daher der beschriebene Algorithmus bessere Ergebnisse als der herkömmliche.

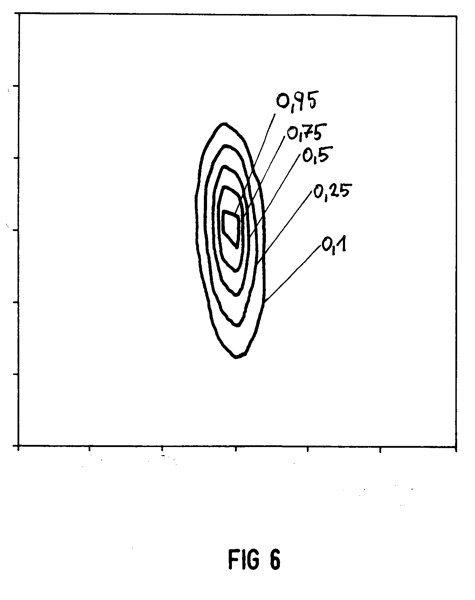

FIG 6 zeigt eine Möglichkeit, die Wahrscheinlichkeitsdichtefunktion in einer Ebene des Untersuchungsvolumens durch Konturlinien zu veranschaulichen. Die Konturlinien zeigen Orte, an denen die Wahrscheinlichkeitsdichtefunktion bestimmte Werte annimmt. Die innerste Linie stellt den höchsten Wert dar, während die äußerste Linie den niedrigsten Wert darstellt. Hier sind z.B. die Linien mit den Werten - von innen nach außen - 0,95/0,75/0,5/0,25/0,1 dargestellt.

Eine farbliche Darstellung der Bereiche zwischen den Konturlinien ist in einem schwarz-weißen Schnittbild gut sichtbar.

**Patentansprüche**

1. Verfahren zur Lokalisierung von im Innern eines Lebewesens in einem Untersuchungsvolumen ablaufenden elektrophysiologischen Aktivitäten, die außerhalb des Untersuchungsvolumens ein meßbares magnetisches und elektrisches Feld erzeugen, welches durch die Wirkung äquivalenter Stromdipole, die sich innerhalb des Untersuchungsvolumens befinden, darstellbar ist, mit den Schritten:
   - Messen des magnetischen und/oder elektrischen Feldes in einer ersten Anzahl von Meßraumpunkten außerhalb des Untersuchungsvolumens mit einer ersten Anzahl von Meßkanälen,
   - Berechnen von lokal-optimalen Stromdipol-Kombinationen, die sich an einer zweiten Anzahl von Jeweils unterschiedlichen Untersuchungs-Raumpunkten innerhalb des Untersuchungsvolumens befinden und die jeweils an den Meßraumpunkten ein magnetisches bzw. elektrisches Feld erzeugen, das mit dem an den Meßraumpunkten gemessenen Feld am besten übereinstimmt,
   - Berechnen einer least-squares-Funktion auf der Grundlage der lokal-optimalen Stromdipol-Kombinationen, die das von den lokal-optimalen Stromdipol-Kombinationen erzeugte Feld an der ersten Anzahl von Meßraumpunkten mit dem gemessenen Feld an diesen Meßraumpunkten vergleicht, wobei die least-squares-Funktion nur eine Funktion von Raumpunkten im Untersuchungsvolumen ist,
   - Berechnen einer exponentiellen Wahrscheinlichkeitsdichtefunktion, deren negativer Exponent die least-squares-Funktion enthält,

- Berechnen eines Orts-Erwartungswertes der Stromdipol-Kombinationen mittels der Wahrscheinlichkeitsdichtefunktion, wobei der Orts-Erwartungswert aus der mit der Gesamtwahrscheinlichkeit normierten Summe der mit der entsprechenden Wahrscheinlichkeitsdichtefunktion gewichteten Untersuchungs-Raumpunkte gebildet wird und den Orten der äquivalenten Stromdipole im Untersuchungsvolumen entspricht.

2. Verfahren nach Anspruch 1, **dadurch gekennzeichnet**, daß der Exponent in seinem Nenner eine über alle Meßkanäle gemittelte quadratische Meßwertrausch-Amplitude enthält.

3. Verfahren nach Anspruch 1 oder 2, **dadurch gekennzeichnet**, daß die lokal-optimalen Stromdipol-Kombinationen Jeweils nur einen lokal-optimalen Stromdipol enthalten.

4. Verfahren nach einem der Ansprüche 1 bis 3, **dadurch gekennzeichnet**, daß aus dem zweiten Moment der Wahrscheinlichkeitsdichtefunktion die Standardabweichung berechnet wird, wobei die Standardabweichung ein Maß für den Fehler bei der Ortsbestimmung des äquivalenten Stromdipols ist.

5. Verfahren nach einem der Ansprüche 1 bis 4, **dadurch gekennzeichnet**, daß die Wahrscheinlichkeitsdichtefunktion und der Orts-Erwartungswert bildlich dargestellt werden.

6. Verfahren nach Anspruch 4 oder 5, **dadurch gekennzeichnet**, daß die Standardabweichung und der Orts-Erwartungswert bildlich dargestellt werden.

7. Verfahren nach Anspruch 5 oder 6, **dadurch gekennzeichnet**, daß ein Bereich der Wahrscheinlichkeitsdichtefunktion, der oberhalb einer ersten Schwelle liegt, kontrastierend zum Bereich unterhalb der ersten Schwelle abgebildet wird.

8. Verfahren nach einem der Ansprüche 5 und 6, **dadurch gekennzeichnet**, daß nur ein Bereich der Wahrscheinlichkeitsdichtefunktion abgebildet wird, der oberhalb einer zweiten Schwelle liegt.

9. Verfahren nach einem der Ansprüche 1 bis 8, **dadurch gekennzeichnet**, daß aus der Wahrscheinlichkeitsdichte für eine vorgebbare Umgebung des Orts-Erwartungswertes die Wahrscheinlichkeit berechnet wird und numerisch dargestellt wird.

## Claims

1. A method for identifying the location of endogenous, in vivo electrophysiological activities occurring in an examination volume, which generate outside the examination volume a measurable magnetic and electrical field which can be represented by the effect of equivalent current dipoles located inside the examination volume, comprising the steps of:
   - measuring the magnetic and/or electrical field for a first plurality of measurement space points outside the examination volume using a first plurality of measuring channels,
   - calculating locally optimum current dipole combinations which are situated at a second plurality of respectively different examination space points within the examination volume, and each of which generates at the measurement space points a magnetic or electrical field best coinciding with the field measured at the measurement space points,
   - calculating a least-squares function on the basis of the locally optimum current dipole combinations which compares the field generated by the locally optimum current dipole combinations at the first plurality of measurement space points with the measured field at these measurement space points, the least-squares function being a function only of space points within the examination volume,
   - calculating an exponential probability density function having a negative exponent containing the least-squares function,
   - calculating an anticipated location value of the current dipole combinations of the basis of the probability density function, wherein the anticipated location value is formed by the sum of the examination space points weighted with the corresponding probability density function, which sum is standardized with the overall probability, and the anticipated location value corresponds to the locations of equivalent current dipoles in the examination volume.

2. A method according to claim 1, characterised in that the denominator of the exponent contains a squared measured value of noise amplitude averaged over all of the measurement channels.

3. A method according to claim 1 or 2, characterised in that the locally optimum current dipole combinations each consist of only one locally optimum current dipole.

4. A method according to one of claims 1 to 3, characterised in that the standard deviation is calculated from the second moment of the probability density function, wherein the standard deviation is a measure for the error in the identification of the location of the equivalent current dipole.

5. A method according to one of claims 1 to 4, characterised in that the probability density function and the anticipated location value are portrayed graphically.

6. A method according to claim 4 or 5, characterised in that the standard deviation and the anticipated location value are portrayed graphically.

7. A method according to claim 5 or 6, characterised in that a region of the probability density function which lies above a first threshold is displayed in contrast with the region lying below the first threshold.

8. A method according to one of claims 5 and 6, characterised in that only one region of the probability density function, which lies above a second threshold, is displayed.

9. A method according to one of claims 1 to 8, characterised in that the probability for a selected environment of the anticipated location value is calculated from the probability density and is numerically displayed.

## Revendications

1. Procédé pour localiser des activités électrophysiologiques qui se déroulent à l'intérieur d'un volume d'examen dans un être vivant et qui produisent, à l'extérieur du volume d'examen, un champ magnétique et électrique mesurables, qui peut être représenté par l'action de dipôles de courant équivalents, qui sont situés à l'intérieur du volume d'examen, comprenant les étapes suivantes :
   - mesure du champ magnétique et/ou électrique en un premier nombre de points de l'espace de mesure à l'extérieur du volume d'examen avec un premier nombre de canaux de mesure,
   - calcul de combinaisons localement optimales de dipôles de courant, qui sont situées en un second nombre de points respectivement différents de l'espace d'examen à l'intérieur du volume d'examen et qui produisent respectivement aux points de l'espace de mesure, un champ magnétique ou électrique, qui coïncide le mieux avec le champ mesuré au niveau des points de l'espace de mesure,
   - calcul d'un fonction least-squares (des moindres carrés) sur la base des combinaisons localement optimales des dipôles de courant, fonction qui compare le champ produit par les combinaisons localement optimales de dipôles de mesure, au niveau du premier nombre de points de l'espace de mesure au champ mesuré en ces points de source de mesure, la fonction least-squares étant seulement une fonction de point de l'espace dans le volume d'examen,
   - calcul d'une fonction de densité de propabilité exponentielle, dont l'exposant négatif contient la fonction least-squares,
   - calcul d'une valeur d'espérance du lieu des combinaisons de dipôles de courant à l'aide de la fonction de densité de probabilité, la valeur d'espérance du lieu étant formée à partir de la somme, normalisée par la probabilité totale, des points de l'espace d'examen pondérés par la fonction de densité de probabilité correspondante, et correspondant aux lieux des dipôles de courant équivalents dans le volume d'examen.

2. Procédé suivant la revendication 1, caractérisé par le fait que l'exposant présente, dans son dénominateur, une valeur moyenne, formée sur tous les canaux de mesure, de l'amplitude quadratique de bruit de la valeur de mesure.

3. Procédé suivant la revendication 1 ou 2, caractérisé par le fait que les combinaisons localement optimales de dipôles de courant contiennent respectivement seulement un dipôle de courant localement optimum.

4. Procédé suivant l'une des revendications 1 à 3, caractérisé par le fait que l'écart-type est calculé à partir du second moment de la fonction de densité de probabilité, l'écart-type étant une mesure de l'erreur lors de la détermination du lieu du dipôle de courant équivalent.

5. Procédé suivant l'une des revendications 1 à 4, caractérisé par le fait qu'on représente la fonction de densité de probabilité et la valeur d'espérance du lieu de façon imagée.

6. Procédé suivant la revendication 4 ou 5, caractérisé par le fait que l'écart-type et la valeur d'espérance du lieu sont représentés d'une manière imagée.

7. Procédé suivant la revendication 5 ou 6, caractérisé par le fait qu'une région de la fonction de densité de probabilité, qui est située au-dessus d'un premier seuil, est reproduite sous la forme d'une image contrastée par rapport à la zone située au-dessous du premier seuil.

8. Procédé suivant l'une des revendications 5 et 6, caractérisé par le fait que seule est formée l'image d'une région de la fonction de densité de probabilité, qui est située au-dessus d'un second seuil.

9. Procédé suivant l'une des revendications 1 à 8, caractérisé par le fait que la probabilité est calculée à partir de la densité de probabilité pour un environnement pouvant être prédéterminé de la valeur d'espérance de lieu et est représentée numériquement.

z = 2.5 cm

FIG 1

z = 0 cm

FIG 2

z = 2.5 cm

FIG 3

z = 5 cm

y          x

FIG 4

z = 7.5 cm

y          x

FIG 5

FIG 6